# EUROPEAN PATENT SPECIFICATION

(11) **EP 3 314 766 B1**
(45) Date of publication and mention of the grant of the patent: **31.07.2019**
(21) Application number: 16733527.2
(22) Date of filing: 29.06.2016
(51) Int. Cl.: H03K 17/78, H02M 3/335, H04B 10/80, H02M 1/00

(54) **OPTOCOUPLER DRIVER CIRCUIT**
TREIBERSCHALTUNG FÜR OPTOKOPPLER
CIRCUIT D'ATTAQUE DE PHOTOCOUPLEUR

(30) Priority: 29.06.2015 GB 201511332
(43) Date of publication of application: 02.05.2018
(73) Proprietor: Eaton Intelligent Power Limited, Dublin 4 (IE)
(72) Inventor: SCHASFOORT, Peter, 7577 GE Oldenzaal (NL)
(74) Representative: Eaton IP Group EMEA
(86) International application number: PCT/EP2016/065204
(87) International publication number: WO 2017/001519

(56) References cited:
- DE-U1-202010 008 133
- GB-A- 1 529 452
- JP-A- H0 548 416
- JP-A- H0 877 902
- JP-A- H01 270 409

## Description

### Field of the invention

The present invention relates to an optocoupler driver circuit, more in particular to an optocoupler driver circuit for transferring data from a line level circuit to an isolated circuit, the optocoupler driver circuit comprising a first and second terminal for a series connection of the optocoupler driver circuit in a supply mains line operating on a first voltage level and supplying electrical power towards a low power supply for powering the isolated circuit, and an optocoupler providing an output signal to the isolated circuit.

### Prior art

Such an optocoupler driver circuit is used in application where the isolated circuit needs information, such as status information, from the line level side, while maintaining galvanic isolation therefrom. An example can be seen in JP H05 48416 A.

### Summary of the invention

The present invention seeks to provide a solution for an optocoupler driver circuit with minimal influence on the rest of the circuit in terms of component and real estate costs, and in terms of power consumption.

According to the present invention, an optocoupler driver circuit according to the preamble defined above is provided, wherein the optocoupler driver circuit further comprises a voltage clamping element connected between the first and second terminal, having a clamping voltage which is a factor x lower than the first voltage level and a switching element driven by an input signal, connected in series with an input side of the optocoupler, wherein the series connection of the switching element and the optocoupler is connected in parallel to the voltage clamping element.

This allows to use the current already flowing to the low power supply for proper and secure operation of the optocoupler, while needing only a minimal number of additional components.

Further embodiments and alternatives are described in the dependent claims, and are further detailed in the detailed description below.

### Short description of drawings

The present invention will be discussed in more detail below, using a number of exemplary embodiments, with reference to the attached drawings, in which
Fig. 1 shows a simplified circuit diagram of an optocoupler driver circuit according to an embodiment of the present invention;
Fig. 2 shows a circuit diagram of an implementation of an optocoupler driver circuit according to a further embodiment of the present invention; and
Fig. 3 shows a circuit diagram of a dual optocoupler driver circuit according to an even further embodiment of the present invention.

### Detailed description of exemplary embodiments

To transfer (binary) information (e.g. status information) from a line level circuit (e.g. mains voltage line) to an isolated circuit, e.g. a safety extra low voltage (SELV) circuit, mostly optocouplers are used, as these provide an excellent opportunity to obtain galvanic separation.

A technical problem is that the LED part of an optocoupler must be driven with a current in excess of a few milli-amperes to guarantee secure and robust operation. A commonly used method is to add a small power supply connected to the line level circuit providing power to the optocoupler driving circuit. The associated cost (in terms of components but also in terms of space needed on a printed circuit board) is high.

According to the present invention embodiments, a current in the line level circuit to an already present power supply (e.g. a low power supply for the isolated circuit) is used to drive the optocoupler for transferring the line level circuit binary information to the isolated circuit side.

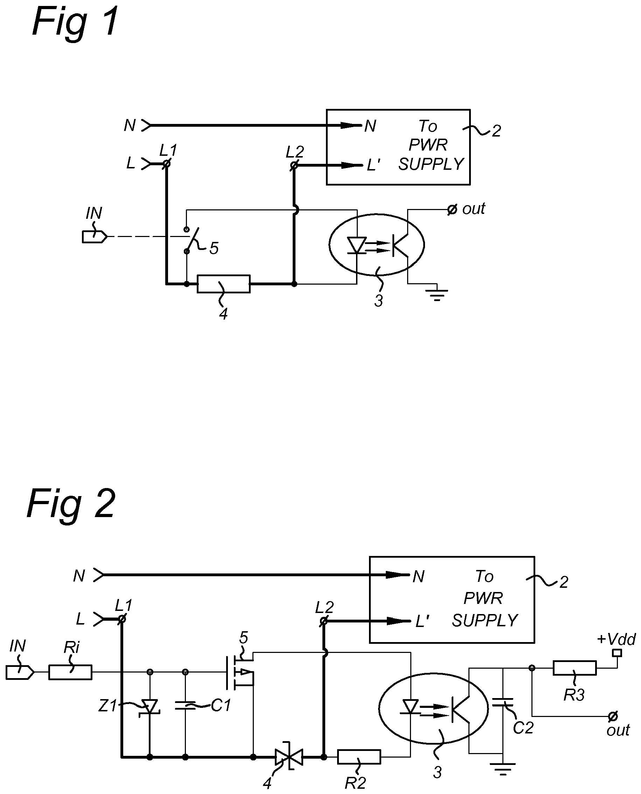

In a generic sense, an optocoupler driver circuit is provided by the present invention embodiments as shown in the simplified circuit diagram of Fig. 1. A low power supply 2 is normally connected to a neutral and live line (N, respectively L') of a line level circuit, e.g. an AC mains line. The low power supply 2 is used to power the isolated circuit to which information has to be conveyed from the line level circuit.

An optocoupler 3 is shown as providing an output O1 on the isolated circuit side, and driven by an input signal IN. The optocoupler driver circuit as shown comprises a first and a second terminal (L1, L2) for a series connection of the optocoupler driver circuit in the (live) supply mains line (L) operating on a first voltage level. The first voltage level is e.g. AC 250V or AC 110V, but can possibly also be for automotive applications, i.e. DC 12 or 24V. This supply mains line L supplies electrical power towards the low power supply 2 for powering the isolated circuit. A voltage clamping element 4 is connected between the first and second terminal L1, L2, and has a clamping voltage which is a factor *x* lower than the first voltage level. A switching element 5 is driven by an input signal IN and is connected in series with an input side of the optocoupler 3. The series connection of the switching element 5 and the optocoupler 3 is connected in parallel to the voltage clamping element 4.

Thus, depending on the (binary) input signal IN, current flowing in the live line L (wherein the optocoupler driver circuit is connected by the first and second terminals L1, L2) is redirected through the optocoupler 3 or not.

The voltage clamping element 4 is e.g. a back-to-back arrangement of two Zener diodes, or, as presently available as a single electronic component, a (bipolar) transient voltage suppression (TVS) diode.

In the case of a line level of AC 250V, the voltage clamping element 4 can be selected as having a clamping voltage of ±5V. With a 1mA current running through the live line L to low power mains supply 2, the power consumption by the optocoupler driver circuit is only 5mW, which is much better than existing solution using a separate power supply for an optocoupler circuit. Furthermore, the voltage drop over the first and second terminal is limited to only 5V, which as compared to the AC level of 250V is also negligible, and will allow the low power supply 2 to function normally.

In further embodiment, the factor x is at least 10, e.g. at least 50. Depending on the precise application, this will keep the voltage drop over the first and second terminals L1, L2 to a level which is not noticeable for proper operation of the low power supply 2.

In Fig. 2 a circuit diagram is shown of a practical implementation of an optocoupler driver circuit according to an embodiment of the present invention. In this case, the switching element 5 is a transistor, more particularly a field effect transistor (FET), the gate of which is connected to the input signal IN via an input resistor Ri. The gate voltage of the FET 5 is protected using a transistor gate protection circuit, comprising a parallel circuit of Zener diode Z1 and first capacitor C2 connected between the gate and source of the FET 5.

In this embodiment, a bipolar TVS diode 4 is used in series with a line voltage of the mains power supply (i.e. connected between first and second terminal L1, L2). The voltage drop over this TVS diode 4 (in this example with a clamping voltage of ±5V) is a square wave of +5V or -5V, will result in only a minor loss in standby power dissipation. E.g. assuming again that the low power supply 2 only needs 1mA, the power consumption is only 5V^{∗}1mA = 5mW. The current of 1 mA is sufficient to drive the LED part of the (anti-parallel connected) optocoupler 3. The voltage drop over the LED part of the optocoupler 3 is about 2.2V, and as a result the current will actually flow through the optocoupler 3 and not through the TVS diode 4.

The clamping element 4 also acts as a protection for both the switching element 5 (i.e. maximum voltages for the FET 5) and the maximum current through the LED part of the optocoupler 3.

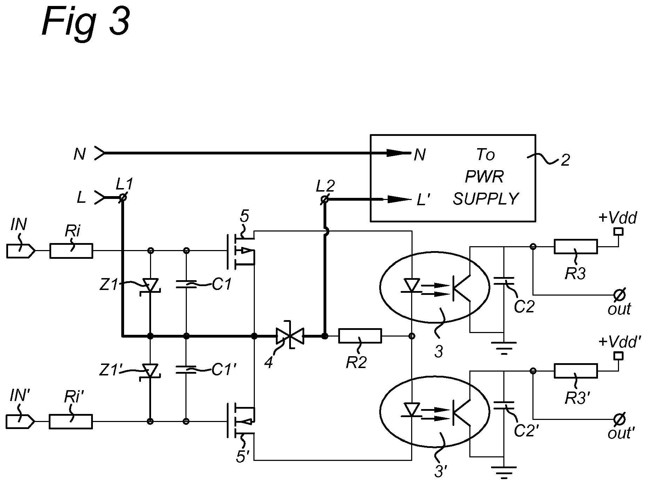

A circuit diagram of a further embodiment of the optocoupler driver circuit of the present invention is shown in Fig. 3. Here, the optocoupler driver circuit further comprises a secondary optocoupler 3' providing a secondary output signal out' to the isolated circuit, and a secondary switching element 5' driven by a secondary input signal, connected in series with an input side of the secondary optocoupler 3'. The series connection of the secondary switching element 5' and secondary optocoupler 3' is connected in parallel to the voltage clamping element 4 (i.e. the same as in the embodiment of Fig. 2). With this embodiment, it is possible to transfer two input signals to the isolated circuit using the dual direction of the AC current in the live line L.

The present invention embodiments have been described above with reference to a number of exemplary embodiments as shown in the drawings. Modifications and alternative implementations of some parts or elements are possible, and are included in the scope of protection as defined in the appended claims.

## Claims

1. Optocoupler driver circuit for transferring data from a line level circuit to an isolated circuit,
the optocoupler driver circuit comprising a first and second terminal (L1, L2) for a series connection of the optocoupler driver circuit in a supply mains line (L) operating on a first voltage level and supplying electrical power towards a low power supply (2) for powering the isolated circuit;
an optocoupler (3) providing an output signal (out) to the isolated circuit;
a voltage clamping element (4) connected between the first and second terminal (L1, L2), having a clamping voltage which is a factor x lower than the first voltage level;
a switching element (5) driven by an input signal, connected in series with an input side of the optocoupler (3),
wherein the series connection of the switching element (5) and the optocoupler (3) is connected in parallel to the voltage clamping element (4).

2. Optocoupler driver circuit according to claim 1, wherein the voltage clamping element (4) is a back-to-back arrangement of two Zener diodes.

3. Optocoupler driver circuit according to claim 1, wherein the voltage clamping element (4) is a transient voltage suppression diode.

4. Optocoupler driver circuit according to any one of claims 1-3, wherein the voltage clamping element (4) has a clamping voltage of ±5V.

5. Optocoupler driver circuit according to any one of claims 1-4, wherein the factor x is at least 10, e.g. at least 50.

6. Optocoupler driver circuit according to any one of claims 1-5, wherein the switching element (5) is a transistor.

7. Optocoupler driver circuit according to claim 6, further comprising a transistor gate protection circuit (Z1, C1).

8. Optocoupler driver circuit according to any one of claims 1-7, wherein the optocoupler driver circuit further comprises
a secondary optocoupler (3') providing a secondary output signal (out') to the isolated circuit, and
a secondary switching element (5') driven by a secondary input signal, connected in series with an input side of the secondary optocoupler (3'),
wherein the series connection of the secondary switching element (5') and secondary optocoupler (3') is connected in parallel to the voltage clamping element (4).

## Patentansprüche

1. Optokoppler-Treiberschaltung zum Übertragen von Daten von einer Schaltung auf Leitungsebene zu einer isolierten Schaltung,
wobei die Optokoppler-Treiberschaltung eine erste und eine zweite Klemme (L1, L2) für eine Reihenschaltung der Optokoppler-Treiberschaltung in einer Netzzuleitung (L) umfasst, die auf einem ersten Spannungspegel arbeitet und einer Schwachstromversorgung (2) zum Versorgen der isolierten Schaltung mit Strom elektrischen Strom zuführt;
einen Optokoppler (3), der ein Ausgangssignal (out) an die isolierte Schaltung bereitstellt;
ein Spannungsklemmelement (4), das zwischen die erste und die zweite Klemme (L1, L2) geschaltet ist und eine Klemmspannung aufweist, die um einen Faktor x niedriger als der erste Spannungspegel ist;
ein Schaltelement (5), das durch ein Eingangssignal angesteuert wird und mit einer Eingangsseite des Optokopplers (3) in Reihe geschaltet ist,
wobei die Reihenschaltung des Schaltelements (5) und des Optokopplers (3) mit dem Spannungsklemmelement (4) parallel geschaltet ist.

2. Optokoppler-Treiberschaltung nach Anspruch 1, wobei das Spannungsklemmelement (4) eine Back-to-back-Anordnung von zwei Zener-Dioden ist.

3. Optokoppler-Treiberschaltung nach Anspruch 1, wobei das Spannungsklemmelement (4) eine Einschwingspannung-Suppressordiode ist.

4. Optokoppler-Treiberschaltung nach einem der Ansprüche 1 bis 3, wobei das Spannungsklemmelement (4) eine Klemmspannung von ±5V aufweist.

5. Optokoppler-Treiberschaltung nach einem der Ansprüche 1 bis 4, wobei der Faktor x mindestens 10, z. B. mindestens 50 beträgt.

6. Optokoppler-Treiberschaltung nach einem der Ansprüche 1 bis 5, wobei das Schaltelement (5) ein Transistor ist.

7. Optokoppler-Treiberschaltung nach Anspruch 6, die weiter eine Transistor-Gate-Schutzschaltung (Z1, C1) umfasst.

8. Optokoppler-Treiberschaltung nach einem der Ansprüche 1 bis 7, wobei die Optokoppler-Treiberschaltung weiter umfasst:
einen sekundären Optokoppler (3'), der ein sekundäres Ausgangssignal (out') an die isolierte Schaltung bereitstellt, und
ein sekundäres Schaltelement (5'), das durch ein sekundäres Eingangssignal angesteuert wird und mit einer Eingangsseite des sekundären Optokopplers (3') in Reihe geschaltet ist,
wobei die Reihenschaltung des sekundären Schaltelements (5') und des sekundären Optokopplers (3') mit dem Spannungsklemmelement (4) parallel geschaltet ist.

## Revendications

1. Circuit de pilotage d'optocoupleur pour transférer des données depuis un circuit de niveau de ligne vers un circuit isolé,
le circuit de pilotage d'optocoupleur comprenant une première et seconde bornes (L1, L2) pour une connexion en série du circuit de pilotage d'optocoupleur dans une ligne d'alimentation secteur (L) fonctionnant sur un premier niveau de tension et fournissant de la puissance électrique vers une alimentation basse puissance (2) pour alimenter le circuit isolé ;
un optocoupleur (3) fournissant un signal de sortie (out) au circuit isolé ;
un élément de fixation de tension (4) connecté entre la première et seconde bornes (L1, L2), présentant une tension de fixation qui est inférieure d'un facteur x au premier niveau de tension ;
un élément de commutation (5) piloté par un signal d'entrée, connecté en série avec un côté d'entrée de l'optocoupleur (3),
dans lequel la connexion en série de l'élément de commutation (5) et de l'optocoupleur (3) est connectée en parallèle de l'élément de fixation de tension (4).

2. Circuit de pilotage d'optocoupleur selon la revendication 1, dans lequel l'élément de fixation de tension (4) est un agencement tête-bêche de deux diodes Zener.

3. Circuit de pilotage d'optocoupleur selon la revendication 1, dans lequel l'élément de fixation de tension (4) est une diode de suppression de tensions transitoires.

4. Circuit de pilotage d'optocoupleur selon l'une quelconque des revendications 1-3, dans lequel l'élément de fixation de tension (4) présente une tension de fixation de ± 5V.

5. Circuit de pilotage d'optocoupleur selon l'une quelconque des revendications 1-4, dans lequel le facteur x est d'au moins 10, par exemple d'au moins 50.

6. Circuit de pilotage d'optocoupleur selon l'une quelconque des revendications 1-5, dans lequel l'élément de commutation (5) est un transistor.

7. Circuit de pilotage d'optocoupleur selon la revendication 6, comprenant en outre un circuit de protection de grille de transistor (Z1, C1).

8. Circuit de pilotage d'optocoupleur selon l'une quelconque des revendications 1-7, dans lequel le circuit de pilotage d'optocoupleur comprend en outre
un optocoupleur secondaire (3') fournissant un signal de sortie secondaire (out') au circuit isolé, et
un élément de commutation secondaire (5') piloté par un signal d'entrée secondaire, connecté en série avec un côté d'entrée de l'optocoupleur secondaire (3'),
dans lequel la connexion en série des élément de commutation secondaire (5') et optocoupleur secondaire (3') est connectée en parallèle de l'élément de fixation de tension (4).
